# EUROPEAN PATENT SPECIFICATION

(11) **EP 1 156 489 B1**
(45) Date of publication and mention of the grant of the patent: **29.12.2004**
(21) Application number: 00964673.8
(22) Date of filing: 04.10.2000
(51) Int. Cl.: G11C 17/00, B41J 2/175

(54) **INTEGRATED CIRCUIT, INK CARTRIDGE, AND INK-JET PRINTER**
INTEGRIERTE SCHALTUNG, TINTENPATRONE UND TINTENSTRAHLDRUCKER
CIRCUIT INTEGRE, CARTOUCHE D'ENCRE ET IMPRIMANTE A JET D'ENCRE

(30) Priority: 04.10.1999 JP 28324399
(43) Date of publication of application: 21.11.2001
(73) Proprietor: SEIKO EPSON CORPORATION, Tokyo 160-0811 (JP)
(72) Inventor: Takagi, Tetsuo, Suwa-shi Nagano-ken 392-8502 (JP)
(74) Representative: Hoffmann, Eckart, Dipl.-Ing.
(86) International application number: PCT/JP2000/006934
(87) International publication number: WO 2001/026114

(56) References cited:
- EP-A- 0 593 282
- WO-A-96/05061
- JP-A- 5 301 349
- JP-A- 9 116 665
- JP-A- 9 213 092
- US-A- 5 832 190
- US-A- 5 955 913

## Description

### Technical Field

The present invention relates to an ink cartridge with a semiconductor integrated circuit having a non-volatile memory, and an inkjet recording device having the ink cartridge attached.

### Background Art

In general, a semiconductor integrated circuit consumes electric power as long as power is supplied even when a predetermined operation is not performed. Thus, there is a need for suppressing the power consumption as much as possible in a stand-by condition where a predetermined operation is not operated. In order to address such a need, it may be possible to add to a semiconductor integrated circuit a function for shifting the operation mode from a general operation mode to a low power consumption operation mode (called stand-by mode, below). In this way, when adding the function for shifting to the stand-by mode, timing for switching between the modes is important. That is, shifting to the stand-by mode at an arbitrary timing may have an influence on regular operations. Thus, it is necessary to switch modes at proper timing.

Further, in order to provide a semiconductor integrated circuit with the function for switching between operation modes, it is necessary to provide a control terminal for receiving control signals for the operation mode shifting. Then, the operation modes can be changed to the stand-by mode by giving a control signal at a predetermined electric potential level to a control terminal for operation mode switching.

By the way, when a plurality of semiconductor integrated circuits is used in one system, a select signal is required for selecting among the plurality of semiconductor circuits. In this case, it is required to provide a device selector terminal for selecting each of the plurality of devices.

Furthermore, it is common to provide a control terminal for circuit block initialization to the semiconductor integrated circuit in order to obtain a function for initializing built-in circuit blocks. In addition, when the circuit blocks are initialized, an internal condition can be set at a predetermined value by supplying a control signal at a predetermined electric potential to the control terminal for circuit block initialization.

In the semiconductor integrated circuit, in order to realize the operation mode switching function and the circuit block initialization function, a control terminal for the above described functions is provided as an independent external terminal along with other external terminals of the semiconductor integrated circuit typicatly including a high potential power supply input terminal, a low potential power supply input terminal, and a reference clock signal input terminal, for example.

However, the semiconductor integrated circuit having the above-described function for shifting to the stand-by mode, the device selecting function, and the circuit block initialization function must include each of a control terminal for memory initialization and a control terminal for operation mode switching. Thus, there have been problems as described below.

That is, an increase in the number of control terminals requires space where the terminals are provided on the outside of the semiconductor integrated circuit. As a result, it causes a problem that the chip size of the semiconductor integrated circuit is increased. In addition, the increase in the number of the control terminals means an increase in the number of electrically coupled external apparatus. This causes a problem in that the cost of assembly is high.

Further, in order to realize each of the above mentioned functions in the semiconductor integrated circuit, it is necessary to generate corresponding control signals to be input to the control terminal for the circuit block initialization and to the control terminal for operation mode switching, respectively. Furthermore, since these control signals must be supplied at a desired timing, there is a problem that the control gets more complicated.

EP 0 593 282 discloses a printing apparatus including an ink cartridge. Built into the ink cartridge are a non-volatile memory and a control unit used for reading from and writing to the memory. The document describes that the recording apparatus is in a "standby mode" whenever it waits for data to be printed.

The present invention was made in order to overcome the above-described problems of the conventional technology. A purpose of the present invention is to provide an ink cartridge with a semiconductor integrated circuit, which allows switching of operation modes at proper timing and reduction of a number of external terminals.

### Disclosure of Invention

This object is achieved by an ink cartridge as claimed in claim 1. Preferred embodiments of the invention are subject-matter of the dependent claims.

### Brief Description of the Drawings

- Fig. 1: is a functional block diagram for describing an example of an internal construction of a semiconductor integrated circuit according to the present invention;
- Fig. 2: is a timing chart for describing a read-out operation on the semiconductor integration circuit;
- Fig. 3: is a timing chart for describing a write operation and others on the semiconductor integrated circuit;
- Fig. 4: is a diagram showing a circuit substrate on which one embodiment of the semiconductor integrated circuit is implemented;
- Fig. 5: is a diagram showing a condition where the circuit substrate shown in Fig. 4 is provided on an ink cartridge;
- Fig. 6: is a diagram showing an overview of an inkjet printer to which the ink cartridge shown in Fig. 5 is attached;
- Fig. 7: is a diagram showing a construction of a carriage shown in Fig. 6.
- Fig. 8: is a diagram showing a condition before an ink cartridge is attached to a holder; and
- Fig. 9: is a diagram showing a condition where an ink cartridge is attached to a holder.

### Best Mode for Carrying Out the Invention

Next, an embodiment of the present invention will be described with reference to drawings. In each of drawings referenced in the description below, parts identical to those in other drawings are denoted by identical reference numerals.

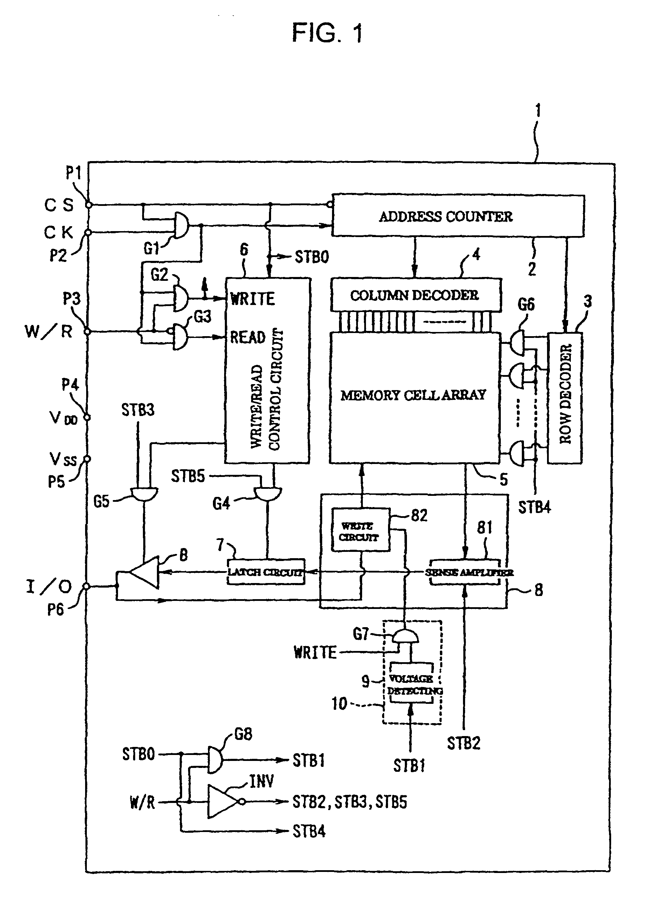

Fig. 1 is a functional block diagram for describing the internal construction of a semiconductor integrated circuit of this embodiment. As shown in the figure, a semiconductor integrated circuit 1 according to this embodiment includes an address counter 2 for performing a count operation, a row decoder 3 and a column decoder 4 for decoding a count value in the address counter 2 in order to create an address, a memory cell array 5 for storing data, a write/read control circuit 6 for controlling a latch circuit 7 and a buffer B depending on writing-in or reading-out for the memory cell array 5, the latch circuit 7 controlled by the write/read control circuit 6 to assume a latch status or a through status, an input/output control circuit 8 for controlling input and output of data to the memory cell array 5, AND gates G1 to G8, the buffer B controlled by the write/read control circuit 6 to assume an enable status or a high-impedance (Hi-Z) status, a voltage detecting circuit 9, and an inverter INV. Further, the semiconductor integrated circuit 1 is provided with external terminals P1 to P6.

The count value of the address counter 2 is initialized to a predetermined value based on the inverted signal of a chip-select input signal CS input to the external terminal P1. Further, the address counter 2 creates updated address data based on a signal input from the AND gate G1. The created address data is input to the row decoder 3 and the column decoder 4.

The column decoder 4 selects the vertical line in the memory cell array 5 that includes a desired memory cell based on address data input from the address counter 2. Similarly, the row decoder 3 selects the horizontal line in the memory cell array 5 that includes the desired memory cell based on address data input from the address counter 2. However, each output line of the row decoder 3 is provided with an AND gate G6, and input to one input of each AND gate G6 is a stand-by signal STB4. Thus, when the stand-by signal STB4 is at low level, a horizontal line of memory cells in the memory cell array 5 is not selected.

The memory cell array 5 is formed by arranging a plurality of memory cells in a matrix. Each memory cell in an addressed row is turned to an ON status by a select signal from the row decoder 3, while a select signal from the column decoder 4 enables information stored in the memory cell to be read and written. In this case, it is assumed that the memory cell array 5 is formed by non-volatile memory cells.

The write/read control circuit 6 determines whether writing to or reading from is performed on the memory cell array 5 based on the chip-select control signal CS input to the external terminal P1 and a signals output from an AND gate G2 or G3. The write/read control circuit 6 outputs a control signal to the latch circuit 7 through an AND gate G4. Therefore, when a stand-by signal STB5 is at a low level, the output of the AND gate G4 is at a low level, whereas when STB5 is at a high level, the output of the AND gate G4 is equivalent to the output signal from the write/read control circuit 6.

The latch circuit 7 outputs read data of the memory cell array 5 to an external terminal P6 after keeping it for a predetermined period of time, which is output from the input/output control circuit 8, based on a control signal from the write/read control circuit 6. The latch circuit 7 performs either a latch operation or a through operation depending on the output of the AND gate G4. The latch circuit 7 performs the latch operation when the output of the AND gate G4 is at the low level, whereas the latch circuit 7 performs the through operation when the output of the AND gate G4 is at the high level. The latch operation is an operation for maintaining the output status. The through operation is an operation for sending out the input signal as an output signal as it is.

The buffer B is provided between the output of the latch circuit 7 and the external terminal P6. The buffer B is turned to an enable status or a high-impedance status depending on the output of the AND gate G5 having, as inputs, a stand-by signal STB3 and a control signal from the write/read control circuit 6. The output for the AND gate G5 is at low level when the output of the stand-by signal STB3 is at the low level, whereas the output of the AND gate G5 is equivalent to the output signal of the write/read control circuit 6 when STB3 is at the high level. When the output of the AND gate G5 is at high level and the buffer B is, thus, in the enable status, the output of latch circuit 7 is passed to the external terminal P6. On the other hand, when the buffer B is in the high-impedance status, a signal supplied to the external terminal P6 is input to the input/output control circuit 8.

The input/output control circuit 8 writes data input via the external terminal P6 into the memory cell array 5, or conversely, outputs read-out data to the external terminal P6 through the latch circuit 7 and the buffer B. The input/output control circuit 8 includes a sense amplifier 81 operated through a stand-by signal STB2, and a write circuit 82 for performing a write operation on the memory cell array depending on the output from a write inhibiting circuit 10 and input/output signals I/O provided from the external terminal P6.

The write inhibiting circuit 10 includes a voltage detecting circuit 9, and an AND gate G7 for controlling transmissions of WRITE signals to the write circuit 82 depending on the output of the voltage detecting circuit 9. The voltage detecting circuit 9 detects a power supply voltage. It detects if the power circuit voltage is the required voltage or above and, if so, enables transmission of the WRITE signal to the write circuit 82 through the AND gate G7. The stand-by signal STB1 turns the output of the voltage detecting circuit to the low level and the current of the voltage detecting circuit to minimum when it is at the low level.

The written data is, for example, the amount of remaining ink. By writing the amount of remaining ink, the amount of remaining ink can be always monitored.

When the stand-by signal STB1 is smaller than a predetermined voltage level, the output of the AND gate G7 is at the low level, and no data writing is performed on the memory cell array 5.

The AND gate G1 outputs, to the address counter 2 and the AND gate G2 or G3, a signal which is the conjunction of the chip-select control signal CS input via the external terminal P1 and a clock input signal CK input via the external terminal P2.

The AND gate G2 outputs, to the write/read control circuit 6, a signal which is the conjunction of the output signal from the AND gate G1 and a write/read input signal W/R from the external terminal P3. On the other hand, the AND gate G3 outputs, to the write/read control circuit 6, a signal which is the conjunction of the output signal from the AND gate G1 and the inverted signal of the write/read input signal W/R from the external terminal P3.

More specifically, when the input signal from the AND gate G1 is "L", the outputs of the AND gates G2 and G3 are both "L". On the other hand, when the input signal from the AND gate G1 is "H", and a write/read input signal W/R is "H", the output of the AND gate G2 is "H" while the output of the AND gate G3 is "L". Conversely, if the write/read input signal W/R is "L", the output of the AND gate G2 is "L" while the AND gate G3 is "H". In this way, the AND gates G2 and G3 are arranged not to vary their outputs even if the write/read input signal W/R varies.

The external terminal P1 is a terminal for inputting the chip-select input signal CS, that is a control signal STB0 for selecting a specific device when a plurality of devices exist at the same time, for initializing the address counter 2, and for shifting the operation mode. That is, the external terminal P1 in this embodiment is a terminal used both as a control terminal for initializing an address counter and as a control terminal for shifting the operation mode.

The external terminal P2 is a terminal for inputting the clock input signal CK that is a reference for the semiconductor integrated circuit 1 to operate. The external terminal P3 is a terminal for inputting the write/read input signal W/R for specifying an access operation on the memory cell array 5 built in the semiconductor integrated circuit 1.

The external terminals P4 and P5 are input terminals for applying operational voltage at a high potential voltage level V_{DD} and at a low potential voltage level V_{SS} for the semiconductor integrated circuit 1 to operate. The external terminal P6 is an input/output terminal for inputting data to be actually written into the memory cell array 5 built in the semiconductor integrated circuit 1 and/or for outputting data read out from the memory cell array 5.

Each of the stand-by signals STB1 to STB5 is generated by an AND gate G8 and an inverter INV. The stand-by signal STB1 is generated by the AND gate G8, which outputs the conjunction of a stand-by signal STB0 and the write/read input signal W/R. Further, the stand-by signals STB2, STB3, and STB5 are generated by the inverter INV, which inverts and outputs the write/read input signal W/R. The stand-by signal STB0 becomes the stand-by signal STB4 as it is.

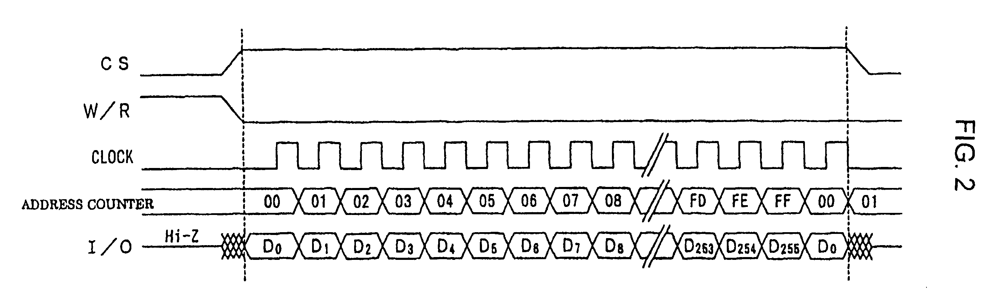

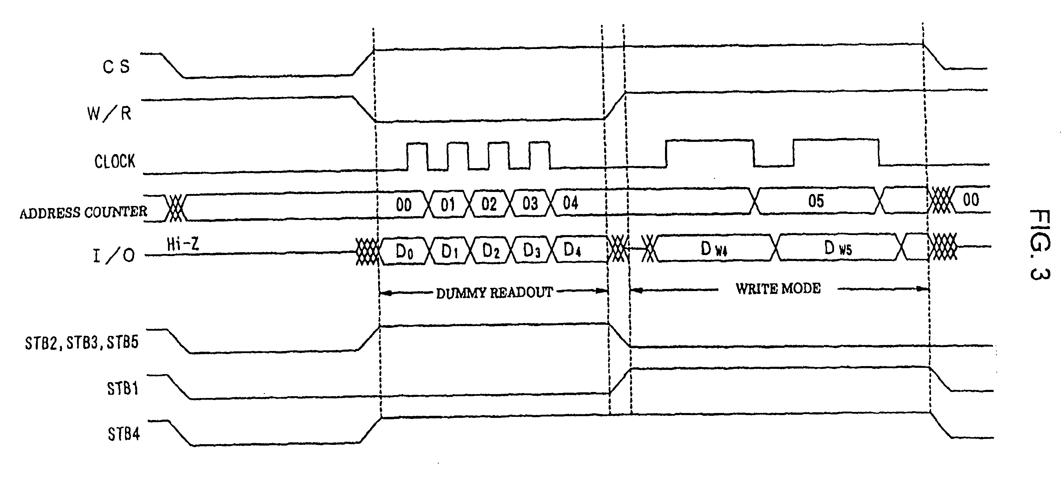

Next, operations of the semiconductor integrated circuit according to this embodiment will be described with reference to Figs. 2 and 3.

Fig. 2 is a timing chart for describing a readout operation on the semiconductor integrated circuit. Fig.2 shows the chip-select control signal CS, the write/read input signal W/R, the clock CLOCK, the count values of the address counter 2, and the input/output signals I/O at the external terminal P6 in Fig. 1. When the readout is performed on the memory cell array 5, "L" is applied to the external terminal P1, first of all, to initialize the address counter 2. Next, "H" is applied to the external terminal P1, and clock pulses for an intended readout start address are input via the external terminal P2. During inputting the clock pulses, "L" for specifying the readout is applied as write/read input signal W/R to the external terminal P3.

The address corresponding to data to be read is output in a period when the clock-input signal CK is turned to "L". During the period when the clock input signal CK is "H", the data is maintained since it is latched within the latch circuit 7 at the leading edge. At the trailing edge, the address is incremented, and data for the next address is output from the external terminal P6.

Fig. 3 is a timing chart for describing a write operation on the semiconductor integrated circuit, for example. Fig. 3 shows the chip-select control signal CS, the write/read input signal W/R, the clock CLOCK, the count values of the address counter 2, the input/output signals I/O at the external terminal P6 as well as the stand-by signals STB1 to STB5. When a write is performed on the memory cell array 5, "L" is applied to the external terminal P1 in a condition where the write/read input signal W/R is "L" in order to initialize the address counter 2. Next, "H" is applied to the external terminal P1, and clock pulses for an intended write start address are input via the external terminal P2. Then, during the write operation, "H" for specifying the write is applied as the write/read input signal W/R to the external terminal P3.

Next, a process for instructing the semiconductor integrated circuit 1 to perform memory initialization and operation mode shifting will be described. As described above, when "L" is applied to the external terminal P1, the address counter 2 is initialized. This is a procedure absolutely required for initialization of the semiconductor integrated circuit 1 and the same is done for circuits other than the memory cell array 5, including the write/read control circuit 6. Here, the output of the buffer B is turned to an i-Z status, which causes the external terminal P6 to assume an open state (high-impedance condition).

In addition, when printing by the inkjet recording device is completed, "L" is applied to the external terminal P1. Then, the stand-by signal STB0 for the operation mode shifting is turned to "L", and the operation mode of the semiconductor integrated circuit 1 is shifted to the stand-by mode. When the operation mode of the semiconductor integrated circuit 1 is shifted to the stand-by mode, operation of parts where current flows steadily is terminated, thereby attempting to reduce the current consumption. More specifically, the sense amplifier 81 provided within the input/output control circuit 8, for example, usually includes a current mirror circuit, and the sense amplifier 81 always needs current flow. Therefore, in order to suppress power consumption in the stand-by mode, the source voltage to supplied to the input/output control circuit 8 is turned to OFF by the stand-by signal STB2. Similarly, the voltage detecting circuit 9 including a current mirror circuit is turned to OFF by the stand-by signal STB1.

Further, the buffer B that is another internal circuit is turned to the high-impedance condition by the stand-by signal STB3. Furthermore, the latch circuit 7 is controlled to the latch condition by the stand-by signal STB5. In addition, specification of addresses by the row decoder 3 is suppressed by the stand-by signal STB4.

Thus, in this embodiment, when the chip-select input signal CS is "L", that is, when the external terminal P1 is in an unselect condition, the address counter 2 is initialized and the semiconductor integrated circuit 1 is shifted to the stand-by mode. Since these instructions are controlled by inputs to the external terminal P1, that is a dual-usage terminal, the memory initialization function and the function for shifting to the stand-by mode are provided, allowing a reduction in the number of the external terminals. Further, the control terminal for the memory initialization and the control terminal for operation mode control are combined to one dual-usage terminal, which makes the control easier.

In this case, the functions for the circuit block initialization and the operation mode shifting may be arranged such that the address counter 2 is initialized and the semiconductor integrated circuit 1 is shifted to the stand-by mode when the logical operation between the input from the external terminal P1 and the input from other terminals is in the unselect condition.

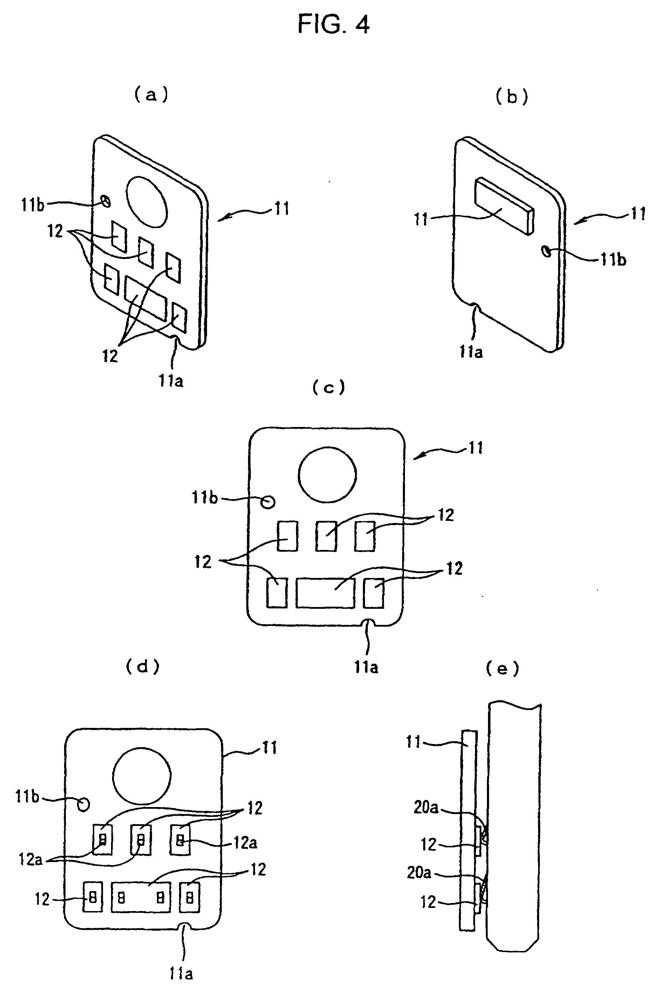

Figs. 4(a) to 4(e) are diagrams showing a circuit substrate on which the semiconductor integrated circuit according to this embodiment is implemented. As shown in Fig. 4(a), contacts 12 are formed on a surface side of a circuit substrate 11. These contacts 12 are connected to the above-described external terminals P1 to P6, Further, as shown in Fig. 4(b), the semiconductor integrated circuit 1 is implemented or mounted on the back side of the circuit substrate 11.

As shown in Fig. 4(c), the circuit substrate 11 is in a substantially rectangular plate form. The circuit substrate 11 is provided with a notch portion 11 a, and a hole portion 1 1 b. They are used for positioning the circuit substrate 11 when mounted on an ink-cartridge described below. Further, as shown in Fig. 4(d), a recess 12a may be provided on the surface of each of the contacts 12 provided on the circuit substrate 11. Providing the recess 12a, as shown in Fig. 4(e) improves the electric connection condition with a contact 29 provided on the ink cartridge described below.

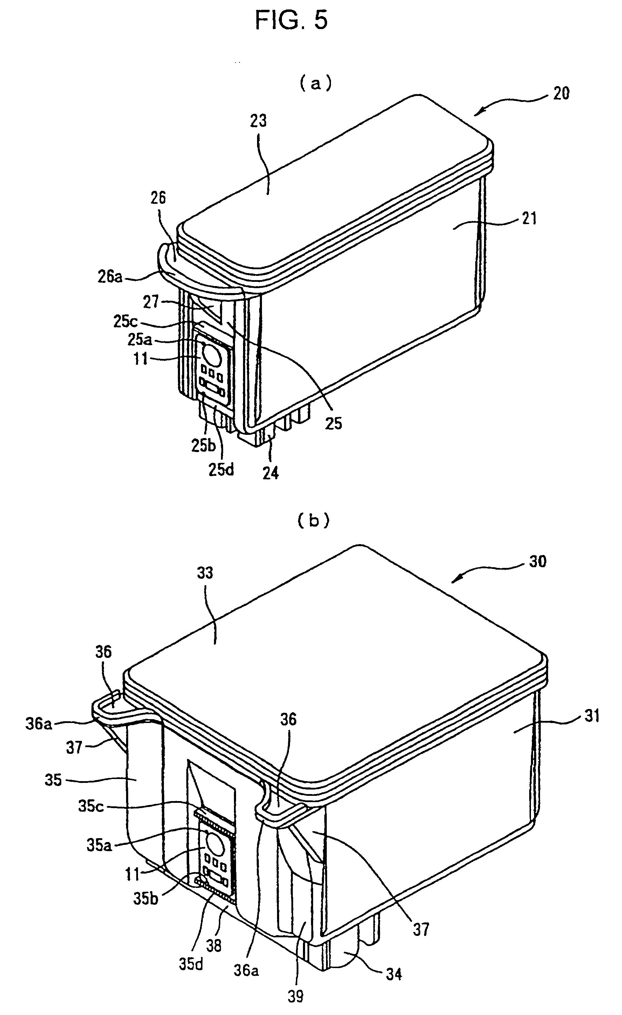

Figs. 5(a) and 5(b) are diagrams showing the circuit substrate shown in Fig. 4 attached to an ink cartridge. Fig. 5(a) shows a case where the circuit substrate 11 is mounted on a black ink cartridge 20 accommodating black ink. The black ink cartridge 20 accommodates, in a container 21 formed as a substantially rectangular parallelepiped, a porous body, not shown, impregnated with black ink, and the top surface is sealed by a lid body 23. On the bottom surface of the container 21, an ink supplying outlet 24 is formed at a position facing an ink supplying needle when attached to a holder. In addition, an overhang portion 26 associated or engaged with a projection of a lever of the body is formed integrally at an upper edge of a vertical wall 25 at the side of the ink supplying outlet. The overhang portions 26 are formed on both sides of the wall 25 separately, and each has a rib 26a. Further, a triangular rib 27 is formed between a bottom surface and the wall 25.

The circuit substrate 11 is attached to the side where the ink supplying outlet of the vertical wall 25 is formed. The circuit substrate 11 has a plurality of contacts on a surface facing the contacts of the body and has a memory element implemented or provided on the back surface. In addition, projections 25a and 25b and overhang portions 25c and 25d are formed on the vertical wall 25 in order to position the circuit substrate 11.

On the other hand, Fig. 5(b) shows a case where the circuit substrate 11 is attached to a color ink cartridge accommodating color ink. The color ink cartridge 30 accommodates, in a container 31 formed as a substantially rectangular parallelepiped, a porous body, not shown, impregnated with ink and sealed with a lid body 33 on the upper surface. Five ink accommodating portions accommodating five colors of color ink separately and respectively are sectionally formed inside of the container 31. At the bottom surface of the container 31, an ink supplying outlet 34 is formed for each ink color at a position facing a respective ink supplying needle when attached to the holder. In addition, overhang portions 36 associated with a projection of a lever of the body are formed integrally at an upper edge of a vertical wall 35 at the side of the ink supplying outlet. The overhang portions 36 are formed on both sides of the wall 35 separately, and each has a rib 36a. Further, a triangular rib 37 is formed between a bottom surface and the wall 35. Furthermore, the container 31 has a recess 39 in order to prevent a mis-insertion.

A recess 38 is formed at a side of the vertical wall 35 where an ink supplying outlet is formed such that it is positioned at the center of each cartridge 30 in the width direction, and the circuit substrate 11 is attached here. The circuit substrate 11 has a plurality of contacts on a surface facing the contacts of the body and has a memory element on the back surface. In addition, projections 35a and 35b and overhang portions 35c and 35d are formed on the vertical wall 35 in order to position the circuit substrate 11.

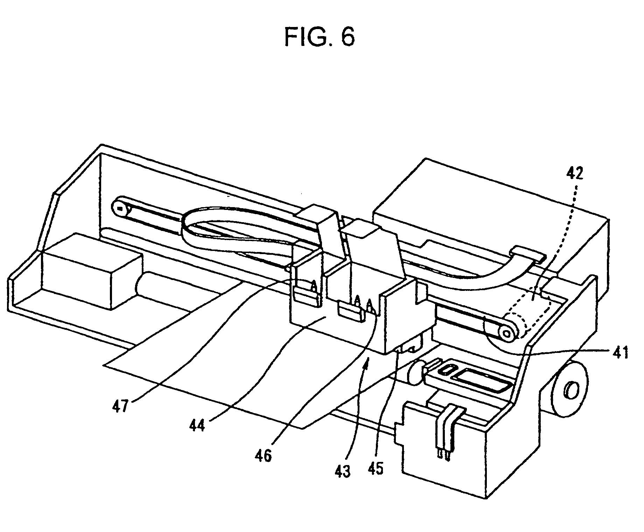

Fig. 6 is a diagram showing an overview of an inkjet printer (inkjet recording device) to which an ink cartridge shown in Fig. 5 is attached. In Fig. 6, a holder 44 for accommodating each of the black ink cartridge 30 shown in Fig. 5(a) and the color ink cartridge 30 shown in Fig. 5(b) is formed in a carriage 43 connected to a driving motor 42 through a timing belt 41. Further, a recording head 45 for receiving the supply of ink from each of the ink cartridges 20 and 30 is provided at a bottom surface position on the carriage 43.

Ink supply needles 46 and 47 communicating with recording head 45 are provided vertically on the bottom surface of the carriage 43 such that they are positioned at the inner part of the device, that is on the side of the timing belt 41.

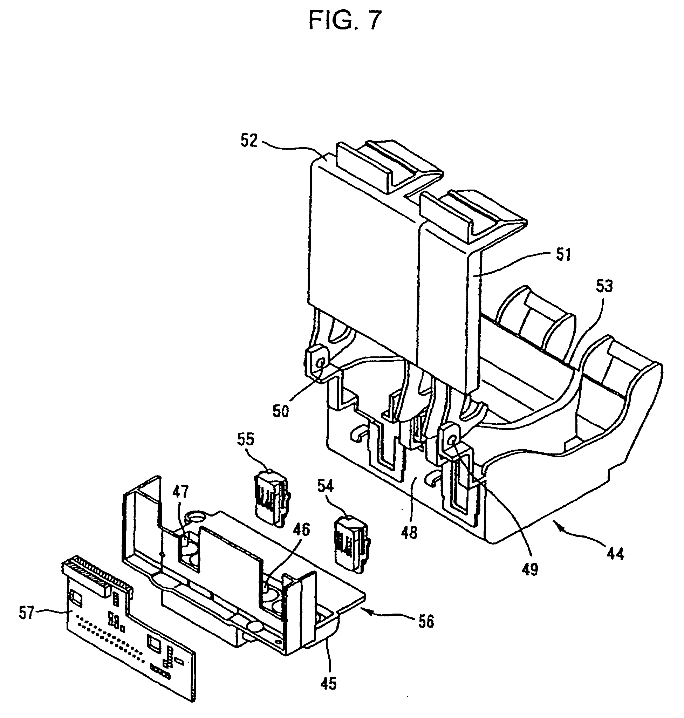

Fig. 7 is a diagram showing the construction of the carriage shown in Fig. 6. As shown in Fig. 7, levers 51 and 52 are mounted rotatably with respect to axes 49 and 50 as fulcrum at the upper edge of a vertical wall 48 closely facing the ink supply needles 46 and 47 among vertical walls forming the holder 44.

The wall 53 positioned on the side of free edges of the levers 51 and 52 has a slope portion where the bottom surface side is cut diagonally. Further, contact mechanisms 54 and 55 are provided on the vertical wall 48. The contact mechanisms 54 and 55 are connected to the above-described contacts provided on the circuit substrate 11 in a condition where the ink-cartridge is attached. Thus, ink-cartridge recording can be performed by using ink within the ink cartridge.

Additionally, a base platform 56 is mounted on the vertical wall 48 of the holder 44. Then, a circuit substrate 57 is mounted on the back surface of the base platform 56. The circuit substrate 57 is electrically connected with the contact mechanisms 54 and 55, resulting in that the circuit substrate 11 and the circuit substrate 57 provided in the ink cartridge are electrically connected.

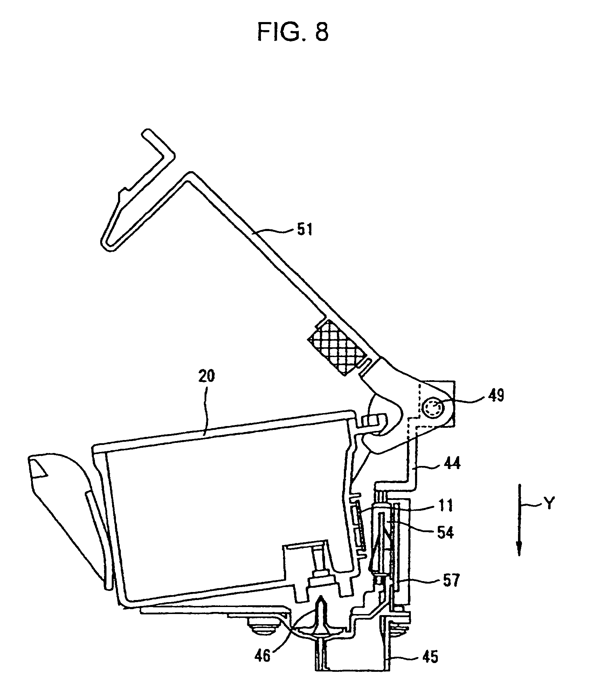

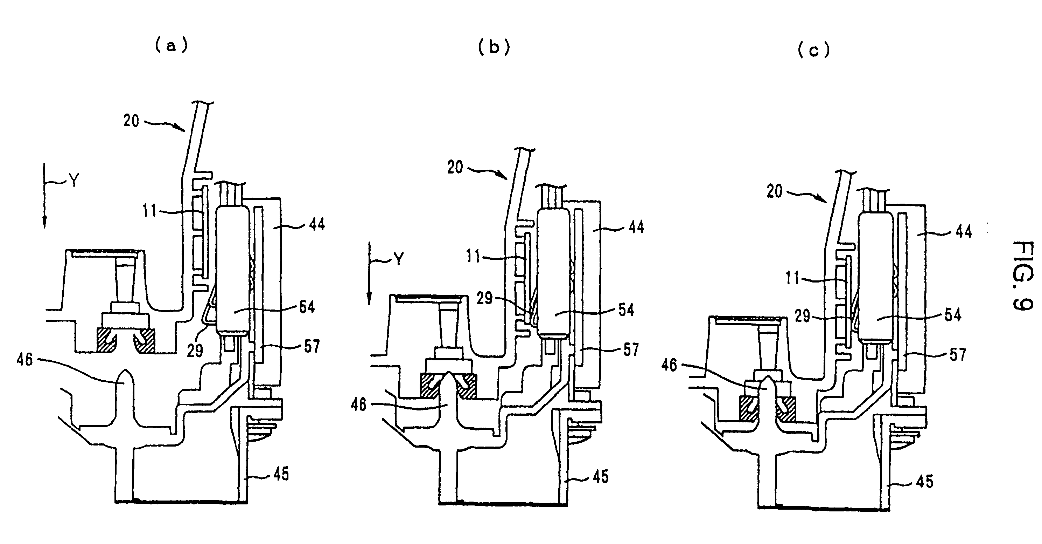

Fig. 8 is a diagram showing the condition before the ink cartridge is attached to the holder, while Figs. 9(a) to (c) are diagrams showing conditions where the ink cartridge is attached to the holder. As shown in Fig. 8, when the lever 51 is closed in a condition where the ink cartridge 20 is inserted to the holder 44, the ink cartridge 20 is pressed gradually in a direction of an arrow Y. Here, the condition shown in Fig. 9(a) turns to the condition shown in Fig. (c), and the ink supply needle 46 is inserted into the ink cartridge 20. Ink is supplied from the ink cartridge 20 in a condition where the ink supply needle 46 is inserted into the ink cartridge 20 and the ink cartridge 20 is attached to the holder 44 completely, that is, in the condition shown in Fig. 9(c).

In the condition shown in Fig. 9(c), the contacts 12 provided on the circuit substrate 11 and the contacts 29 on the circuit substrate 57 provided on the side of the holder 44 are electrically connected. Thus, an inkjet printer can read and write data freely to/from the semiconductor integrated circuit 1. More specifically, when the power supply of the printer is ON, "L" is applied to the external terminal P1, while "H" is applied when a read or write operation needs to be performed. It can simplify the logic and contribute to the reduction of the chip size.

### Industrial Applicability

As described above, by controlling to shift to the low power consumption mode in response to an end of a printing operation using an ink cartridge, the operation mode can be shifted without having any effect on the regular operation. In the low power consumption mode, initializing a specified address can achieve the reduction of the power consumption. Additionally, in the low power consumption mode, terminating operations of a sense amplifier for generating signals upon reading out stored data, a buffer used for reading out read data, and a latch circuit for latching read data, for example, can reduce the power consumption even further.

Further, using a common terminal for instructing the chip-select function, the initialization function for circuit blocks, and the function for shifting to the stand-by mode can achieve a semiconductor integrated circuit having a reduced number of external terminals.

Furthermore, by storing the remaining amount of ink in an ink cartridge, at least, the remaining amount of ink cartridge can be always monitored.

## Claims

1. An ink cartridge comprising a semiconductor integrated circuit (1) having a low power consumption mode in which the power consumption is lower than in a regular operation mode performing a regular operation, said semiconductor integrated circuit (1) comprising control means (G8, INV) for controlling a shift to said low power consumption mode in response to an end of a printing operation using the ink cartridge, and further comprising storage means (5) for storing predetermined data at specified addresses, and address creating means (2) for sequentially creating addresses specified for said storage means (5), wherein said address is initialized when operation is shifted to the low power consumption mode responsive to said control means (G8, INV).

2. The ink cartridge of claim 1, wherein in said semiconductor integrated circuit (1), the operation of internal circuits is terminated in the low power consumption mode caused by said control means (G8, INV).

3. The ink cartridge of claim 2, wherein said internal circuits include a sense amplifier (81) for creating a signal upon reading out data stored in said storage means (5).

4. The ink cartridge of claim 2 or 3, wherein said internal circuits include an address decoder (3, 4) for specifying an address in said storage means (5).

5. The ink cartridge of claim 2, 3 or 4, wherein said internal circuits include a buffer (B) used for reading out data read out from said storage means (5).

6. The ink cartridge of any of claims 2 to 5, wherein said internal circuits include a latch circuit (7) for latching data read out from said storage means (5).

7. The ink cartridge of any one of claims 1 to 6, wherein a shift to the low power consumption mode by said control means (G8, INV) and an initialization of address created by said address creating means (2) are performed based on a control signal input to a common external terminal (P1), the control signal being generated in response to an end of a printing operation using the ink cartridge.

8. The ink cartridge of claim 7 wherein said common external terminal (P1) is a chip-select terminal.

9. The ink cartridge of any one of claims 1 to 8, wherein said a semiconductor integrated circuit (1) stores at least the remaining amount of ink.

10. An inkjet recording device having an ink cartridge according to claim 9 for printing desired image information by using ink supplied from the ink cartridge.

## Patentansprüche

1. Tintenpatrone aufweisend eine integrierte Halbleiterschaltung (1) mit einem Modus mit niedriger Leistungsaufnahme, in dem die Leistungsaufnahme niedriger ist als im Normalbetrieb, in dem eine normale Operation ausgeführt wird, wobei die integrierte Halbleiterschaltung (1) Steuermittel (G8, INV) zum Steuern des Umschaltens in den Modus mit niedriger Leistungsaufnahme als Reaktion auf das Ende einer Druckoperation mittels der Tintenpatrone aufweist, und ferner Speichermittel (5) zum Speichern vorgegebener Daten an einer angegebenen Adresse und Adresserzeugungsmittel (2) zum sequentiellen Erzeugen von für die Speichermittel (5) angegebenen Adressen aufweist, wobei die Adresse initialisiert wird, wenn der Betrieb als Reaktion auf die Steuermittel (G8, INV) in den Modus mit niedriger Leistungsaufnahme umgeschaltet wird.

2. Tintenpatrone nach Anspruch 1, bei der in der integrierten Halbleiterschaltung (1) der Betrieb interner Schaltungen im Modus mit niedriger Leistungsaufnahme auf Veranlassung der Steuermittel (G8, INV) beendet wird.

3. Tintenpatrone nach Anspruch 2, bei der die internen Schaltungen einen Leseverstärker (81) zum Erzeugen eines Signals beim Auslesen von in den Speichermitteln (5) gespeicherten Daten enthalten.

4. Tintenpatrone nach Anspruch 2 oder 3, bei der die internen Schaltungen einen Adressdecodierer (3, 4) zum Angeben einer Adresse in den Speichermitteln (5) enthalten.

5. Tintenpatrone nach Anspruch 2, 3 oder 4, bei der die internen Schaltungen einen Puffer (B) zur Verwendung beim Auslesen von aus den Speichermitteln (5) ausgelesenen Daten enthalten.

6. Tintenpatrone nach einem der Ansprüche 2 bis 5, bei der die internen Schaltungen eine Latch-Schaltung (7) zum Zwischenspeichern der aus den Speichermitteln (5) ausgelesenen Daten enthalten.

7. Tintenpatrone nach einem der Ansprüche 1 bis 6, bei der ein Umschalten in den Modus mit niedriger Leistungsaufnahme durch die Steuermittel (G8, INV) und eine Initialisierung einer von den Adresserzeugungsmitteln (2) erzeugten Adresse auf Basis eines Steuersignals erfolgen, das in einen gemeinsamen externen Anschluss (P1) eingegeben wird, wobei das Steuersignal als Reaktion auf das Ende einer Druckoperation mittels der Tintenpatrone erzeugt wird.

8. Tintenpatrone nach Anspruch 7, bei der der gemeinsame externe Anschluss (P1) ein Chipwahl-Anschluss ist.

9. Tintenpatrone nach einem der Ansprüche 1 bis 8, bei der die integrierte Halbleiterschaltung (1) zumindest die restliche Tintenmenge speichert.

10. Tintenstrahl-Aufzeichnungsgerät mit einer Tintenpatrone nach Anspruch 9 zum Drucken gewünschter Bildinformationen durch Verwenden von Tinte, die von der Tintenpatrone geliefert wird.

## Revendications

1. Cartouche d'encre comprenant :
un circuit (1) intégré à semi-conducteurs comportant un mode à faible consommation d'énergie, sous lequel la consommation d'énergie est plus faible que sous un mode de fonctionnement normal assurant un fonctionnement normal, le circuit (1) intégré à semi-conducteurs comprenant :
un moyen (G8, INV) de commande destiné à commander un passage sous le mode à faible consommation d'énergie, en réponse à la fin d'une opération d'impression utilisant la cartouche d'encre,
un moyen (5) de mémorisation pour mettre en mémoire des données déterminées à l'avance, à des adresses spécifiées, et
un moyen (2) de création d'adresses destiné à créer en séquence des adresses spécifiées pour le moyen (5) de mémorisation,
dans laquelle l'adresse est initialisée lorsque le fonctionnement passe sous le mode à faible consommation d'énergie, en réponse au moyen (G8, INV) de commande.

2. Cartouche d'encre suivant la revendication 1 où dans le circuit (1) intégré à semi-conducteurs, le fonctionnement de circuits internes prend fin sous le mode à faible consommation d'énergie engendré par le moyen (G8, INV) de commande.

3. Cartouche d'encre suivant la revendication 2, dans laquelle les circuits internes comprennent un amplificateur (81) de lecture destiné à produire un signal lors de l'extraction de données mémorisées dans le moyen (5) de mémorisation.

4. Cartouche d'encre suivant la revendication 2 ou 3, dans laquelle les circuits internes comprennent un décodeur (3, 4) d'adresse pour spécifier une adresse dans le moyen (5) de mémorisation.

5. Cartouche d'encre suivant la revendication 2, 3 ou 4, dans laquelle les circuits internes comprennent une mémoire (B) tampon utilisée pour extraire des données extraites du moyen (5) de mémorisation.

6. Cartouche d'encre suivant l'une quelconque des revendications 2 à 5, dans laquelle les circuits internes comprennent un circuit (7) à verrouillage pour verrouiller des données extraites du moyen (5) de mémorisation.

7. Cartouche d'encre suivant l'une quelconque des revendications 1 à 6, dans laquelle un passage sous le mode à faible consommation d'énergie à l'aide du moyen (G8, INV) de commande et une initialisation d'adresse créée par le moyen (2) de création d'adresses s'accomplissent sur la base d'un signal de commande appliqué à une borne (P1) externe commune, le signal de commande étant produit en réponse à la fin d'une opération d'impression utilisant la cartouche d'encre.

8. Cartouche d'encre suivant la revendication 7, dans laquelle la borne (P1) externe commune est une borne de sélection de circuit.

9. Cartouche d'encre suivant l'une quelconque des revendications 1 à 8, dans laquelle un circuit (1) intégré à semi-conducteurs mémorise au moins la quantité restante d'encre.

10. Dispositif d'enregistrement à jet d'encre comportant une cartouche d'encre suivant la revendication 9 pour imprimer des données d'image souhaitées au moyen de l'encre fournie par la cartouche d'encre.
